(19) Europäisches Patentamt
European Patent Office
Office européen des brevets

(11) **EP 3 056 547 B1**

(12) **EUROPEAN PATENT SPECIFICATION**

(45) Date of publication and mention
of the grant of the patent:
**27.12.2017 Bulletin 2017/52**

(51) Int Cl.:
*C08L 101/12* (2006.01)  *C08K 3/08* (2006.01)
*C08K 13/04* (2006.01)  *H01B 1/22* (2006.01)
*H01B 5/16* (2006.01)  *H03K 17/96* (2006.01)
*G06F 3/044* (2006.01)  *C08K 7/06* (2006.01)

(21) Application number: **14867700.8**

(22) Date of filing: **29.09.2014**

(86) International application number:
**PCT/JP2014/075851**

(87) International publication number:
**WO 2015/083421 (11.06.2015 Gazette 2015/23)**

(54) **CONDUCTIVE MATERIAL AND TRANSDUCER USING SAME**

LEITFÄHIGES MATERIAL UND WANDLER DAMIT

MATÉRIAU CONDUCTEUR ET TRANSDUCTEUR L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.12.2013 JP 2013249076**

(43) Date of publication of application:
**17.08.2016 Bulletin 2016/33**

(73) Proprietors:
• **Sumitomo Riko Company Limited**
**Komaki-shi, Aichi 485-8550 (JP)**
• **Kyushu University,**
**National University Corporation**
**Fukuoka-shi, Fukuoka 812-8581 (JP)**

(72) Inventors:
• **TAGUCHI Yutaro**
**Komaki-shi**
**Aichi 485-8550 (JP)**
• **YOSHIKAWA Hitoshi**
**Komaki-shi**
**Aichi 485-8550 (JP)**
• **TORIHARA Hidetsugu**
**Fukuoka-shi**
**Fukuoka 812-8581 (JP)**
• **TSUJI Masaharu**
**Fukuoka-shi**
**Fukuoka 812-8581 (JP)**
• **TAKAHARA Atsushi**
**Fukuoka-shi**
**Fukuoka 812-8581 (JP)**

(74) Representative: **Müller-Boré & Partner Patentanwälte PartG mbB Friedenheimer Brücke 21 80639 München (DE)**

(56) References cited:
EP-A1- 0 306 671      WO-A1-2009/107694
WO-A1-2013/047197   WO-A2-2007/022226
WO-A2-2013/154490   JP-A- 2010 153 364
JP-A- 2011 029 099    JP-A- 2011 070 968
JP-A- 2012 009 383    JP-A- 2012 138 260
US-A1- 2009 129 004   US-A1- 2011 162 870
US-A1- 2012 196 114   US-B1- 7 220 131

**Description**

TECHNICAL FIELD

The present invention relates to a flexible conductive material containing metal nanowires, and a transducer in which the conductive material is used as a material for wirings and the like.

BACKGROUND ART

Highly flexible, small, and light transducers have been developed by using polymer materials such as elastomers. Such a transducer includes a dielectric layer made of an elastomer between electrodes, for example. As the voltage applied between electrodes changes, the dielectric layer is extended or contraction. On this account, in a flexible transducer, electrodes and wirings are required to have elasticity so as to follow deformation of the dielectric layer. As an elastic conductive material, for example, a conductive film in which a metal filler that is flaky, fibrous, or the like is dispersed in an elastomer is disclosed in Patent Documents 1 and 2. Meanwhile, as disclosed in Patent Documents 3 to 5, transparent conductive films containing metal nanowires have.been used as transparent electrodes for displays and touch panels. Metal nanowires are suitable as conductive materials because they are highly conductive. US 7220131 discloses an interconnect device and a method to produce such device with nanowires, nanorods etc.

Prior Art Documents

Patent Documents

Patent Document 1: Japanese Patent Application Publication No. 2012-138260 (JP 2012-138260 A)
Patent Document 2: Japanese Patent Application Publication No. 2010-153364 (JP 2010-153364 A)
Patent Document 3: Japanese Patent Application Publication No. 2009-140788 (JP 2009-140788 A)
Patent Document 4: International Publication No. WO2009/107694
Patent Document 5: Japanese Patent Application Publication No. 2011-70968 (JP 2011-70968 A)

SUMMARY OF THE INVENTION

Problem to be Solved by the Invention

Electrodes and wirings used in deformable electronic parts such as transducers are required to be elastic to follow deformation, and when the electrodes and wirings are extended, change of electrical resistance must be small. In conventional flaky metal fillers, the fillers are easily contacted with each other compared with spherical metal fillers having smaller aspect ratios. Thus, when deformation is relatively small, desired conductivity can be kept upon extension. However, when deformation becomes larger, conductive pathways of metal fillers are broken, and desired conductivity cannot be kept. One solution may involve increasing the number of points that metal fillers are contacted with each other by increasing aspect ratios of the fillers; however, there is a limitation to make a metal filler thinner at present, and thus increasing aspect ratios by making pieces thinner is difficult.

In this point of view, the metal nanowires disclosed in Patent Documents 3 to 5 have relatively large aspect ratios. However, the metal nanowires tend to be aggregated. For example, as a growth direction control agent of silver nanowires, a hydrophilic polymer such as polyvinylpyrrolidone (PVP) is used for manufacturing silver nanowires. The growth direction control agent attaches to surfaces of silver particles to grow the silver particles in a single direction. Therefore, polyvinylpyrrolidone is attached onto the surfaces of the manufactured silver nanowires. Because of its hydrophilicity, compatibility of polyvinylpyrrolidone to hydrophobic polymers is low. Accordingly, if silver nanowires, on which polyvinylpyrrolidone is attached, are mixed in polymers, the silver nanowires are aggregated to form large aggregates. In this case, conductive regions in the aggregates are divided by non-conductive regions in the polymers, and thus conductive pathways cannot be sufficiently formed in the polymers. Accordingly, desired conductivity is difficult to be obtained, and electrical resistance is significantly increased upon extension. In addition, interfaces between aggregates and polymers tend to be cracked upon extension, and thus materials can be easily destroyed. Meanwhile, if silver nanowires alone are dispersed in polymers, for example, by completely removing the growth direction control agent, the number of points that silver nanowires are contacted with each other is decreased. Accordingly, electrical resistance may be increased upon extension.

In view of the above circumstances, an object of the present invention is to provide a conductive material that contains metal nanowires and is highly extensible, in which electrical resistance is not easily increased upon extension. Another object of the present invention is to provide a transducer, whose performance is not easily lowered, and which is highly durable, by using such conductive materials in electrodes and wirings.

Means for Solving the Problem

(1) In order to solve the problem, a conductive material according to the present invention is characterized by including a polymer having a glass transition temperature (Tg) of 25°C or below and a metal filler containing metal nanowires. The conductive material includes a structure in which wire bundle portions each formed by assembling the metal nanowires are dispersed in the polymer.

In the conductive material according to the present invention, the metal nanowires are not dispersed independently, but the wire bundle portions in each of which the metal nanowires are assembled are dispersed. Accordingly, the number of points that the metal nanowires are contacted with each other is increased compared with the case that the metal nanowires are dispersed independently. Accordingly, even if extension is large, conductive pathways of the metal nanowires are not easily broken and conductivity of the conductive material can be kept. In addition, unlike the case where metal nanowires make large aggregates, the size of the wire bundle portion is relatively small, and a large number of wire bundle portions are present closely with each other in a polymer. Thus, the conductive pathways can certainly be formed in the polymer, and electrical resistance is not easily increased even if extension is large. In addition, cracks are less likely to occur upon extension, and the conductive material is not easily destroyed if the extension is repeated.

Thus, in the conductive material according to the present invention, metal nanowires are dispersed as appropriately aggregated. Accordingly, the novel property that electrical resistance is not easily increased even if extension is large can be provided. Also in the conductive material according to the present invention, the polymer having a Tg of 25°C or below is used as a base material. Accordingly, the conductive material according to the present invention is flexible. Note that the conductive material according to the present invention may have metal nanowires that are present individually without forming any wire bundles. In addition, the conductive material according to the present invention may have metal fillers other than metal nanowires.

(2) A transducer according to the present invention is characterized by including a dielectric layer made of an elastomer, a plurality of electrodes with the dielectric layer interposed therebetween, and wirings each connecting to corresponding one of the electrodes. In the transducer, either one or both of the electrodes and the wirings include the conductive material according to the present invention.

Examples of the transducer include actuators, sensors, power generation devices, etc. that perform the conversion between mechanical energy and electric energy and speakers, microphones, etc. that perform the conversion between acoustic energy and electric energy. In the transducer according to the present invention, either one or both of the electrodes and the wirings include the conductive material according to the present invention. Thus, when the dielectric layer is deformed, the electrodes and the wirings are extended or contraction following the deformation. Thus, in the transducer according to the present invention, the movement of the dielectric layer is less likely to be restricted by the electrodes and the wirings. In addition, the electrodes and the wirings composed of the conductive material according to the present invention have high conductivity and have electrical resistance that is less likely to increase even when the electrodes and the wirings are extended. Thus, the transducer according to the present invention has a performance that is less likely to deteriorate due to the electrodes or the wirings. The transducer according to the present invention therefore has excellent durability.

BRIEF DESCRIPTION OF THE DRAWINGS

[FIG. 1] FIG. 1 is a top view of a capacitance sensor as one embodiment of the transducer according to the present invention.
[FIG. 2] FIG. 2 is a sectional view taken along line II-II in FIG. 1.
[FIG. 3] FIG. 3 is a sectional SEM picture of the conductive film of Example 1 (magnification: ×20,000).
[FIG. 4] FIG. 4 is a sectional SEM picture of the conductive film of Example 2 (magnification: ×20,000).
[FIG. 5] FIG. 5 is a sectional SEM picture of the conductive film of Comparative Example 1 (magnification: ×20,000).
[FIG. 6] FIG. 6 is a sectional SEM picture of the conductive film of Comparative Example 2 (magnification: ×8,000).

Description of the Reference Numerals

2: capacitance sensor (transducer); 20: dielectric layer; 21a, 21b: electrode; 22a, 22b: wiring; 23a, 23b: cover film; 24: connector

MODES FOR CARRYING OUT THE INVENTION

Embodiments of a conductive material and a transducer according to the present invention will be described hereinafter. The conductive material and the transducer according to the present invention are not limited to the embodiments below, and various modifications, improvements, and other changes may be made thereto by a person skilled in the art without departing from the scope of the present invention.

<Conductive Material>

The conductive material according to the present invention includes a polymer having a glass transition temperature (Tg) of 25°C or below and a metal filler containing metal nanowires; and the conductive material includes a structure in which wire bundle portions each formed by assembling the metal nanowires are dispersed in the polymer.

[Polymer]

A polymer for the conductive material according to the present invention has a Tg of 25°C or below in view of flexibility. When the Tg is lowered, tendency to be crystalline is lowered, and thus flexibility of the polymer is improved. Accordingly, a polymer having a Tg of 5°C or below is more preferable to use. In the present specification, a middle glass transition temperature measured according to JIS K7121 (1987) is used as a Tg.
One kind of polymer can be used alone, or two or more kinds of polymers can be used as a mixture. Examples of the polymer include acrylic rubber, urethane rubber, silicone rubber, butyl rubber, butadiene rubber, ethylene oxide-epichlorohydrin copolymers, nitrile rubber, hydrogenated nitrile rubber, chloroprene rubber, natural rubber, isoprene rubber, styrene-butadiene rubber, ethylene-propylene-diene copolymers (EPDM), silicone rubber, polyester resins, and polyester urethane resins. Among them, acrylic rubber has a low degree of crystallinity, and has weak intermolecular force, and thus has a lower Tg than that of other rubbers. Accordingly, acrylic rubber is flexible, and can be extended well. In addition, when a transducer is composed of acrylic rubber, the transducer sticks well to a dielectric layer composed of nitrile rubber, and ionic impurities are less. Thus, acrylic rubber is preferable as a conductive material according to the present invention when the conductive material is used for electrodes and wirings of a transducer. In addition, although polyester resins and polyester urethane resins having lower Tgs have higher breaking strength, they also have higher breaking elongation. Thus, polyester resins and polyester urethane resins are also suitable.

[Metal Filler]

Metal nanowires are included in metal fillers that are mixed in polymers. Materials of the metal nanowires are not particularly limited. Examples of the metal include silver, gold, copper, platinum, and nickel. Metals composing the nanowires can be one kind, or can be two or more kinds. Among them, silver nanowires containing silver are preferable, because of their high conductivity and relatively low prices. Metal nanowires contained in conductive materials can be one kind, or can be two or more kinds.
The size of metal nanowires is not particularly limited. For example, if the length in the transverse direction (diameter) of a metal nanowire is small, that is, if the metal nanowire becomes thin, aggregation force becomes large, and wire bundle portions can easily be formed. Accordingly, the number of points that metal nanowires are contacted with each other is increased, and an increase in electrical resistance upon extension will be highly suppressed. Thus, an average length in the transverse direction of the metal nanowires is preferably 200 nm or less, and more preferably 150 nm or less. In addition, if the length in the longitudinal direction of a metal nanowire is small, that is, if the metal nanowire becomes short, metal nanowires are not easily contacted with each other. Accordingly, conductive pathways are not easily formed. In addition, if the number of contacting points becomes small, electrical resistance can easily be increased upon extension. Thus, an average length in the longitudinal direction of the metal nanowires is preferably 1 $\mu$m or more, and more preferably 2 $\mu$m or more. The size of the metal nanowire can be determined by measuring the length of each of the metal nanowires by observing the section of the conductive material with a scanning electron microscope (SEM) or a transmission electron microscope (TEM); and calculating the size from an arithmetic mean value of measurement values, in which the number of measurements is given. The number of metal nanowires to measure is preferably at least 20 or more.

In the conductive material according to the present invention, a plurality of metal nanowires are assembled to form a wire bundle portion. Whether any wire bundle portions are present can be observed by observation of the section of the conductive material with SEM, TEM, etc. For example, a portion where metal nanowires are adjacent or contacted to be assembled at a distance therebetween of less than 200 nm can be approved as a wire bundle portion.

The number of metal nanowires composing one wire bundle portion is not particularly limited. The suitable number of metal nanowires is, for example, 2 or more, but not more than 400. If the size of the wire bundle portion is too large, material destruction may begin at the wire bundle portion upon deformation. Thus, an average number of metal nanowires composing one wire bundle portion is preferably 100 or less, more preferably 50 or less.

The wire bundle portions are dispersed in a polymer. In order to effectively suppress an increase in electrical resistance upon extension, the distance between adjacent wire bundle portions is preferably less than 3 $\mu$m.

As mentioned above, hydrophilic polymers used at the time of manufacture are attached onto the surfaces of unpurified metal nanowires. If metal nanowires on which hydrophilic polymers remain attached are used, aggregates in which a large number of metal nanowires are aggregated tend to be formed instead of wire bundles. Accordingly, metal nanowires are preferably washed before mixed in a polymer, so as to remove hydrophilic polymers attached on the surfaces of the metal nanowires. Note that if hydrophilic polymers are completely removed, aggregation force becomes small, and wire bundle portions cannot easily be formed. Thus, a washing process is preferably conducted so that a metal component in metal nanowires is 85% by mass or more, but not more than 99.5% by mass. The washing process of metal nanowires can be conducted by, for example, adding a solvent to synthesized metal nanowires, and stirring under heating. In this case, extent of removal of hydrophilic polymers may be adjusted by a temperature at the time of the heating and stirring process, a stirring time, the number of repeat, an amount of a solvent, and the like. The metal component in metal nanowires can be identified by thermal gravimetry (TG). Specifically, heating about 5 mg of metal nanowires from a room temperature to 1,000°C with the rate of 20°C/minute, and calculating a ratio of mass after heating to the mass before heating.

Thus, metal nanowires, in which the hydrophilic polymers are appropriately removed, are preferably used in the conductive material according to the present invention. A small amount of hydrophilic polymers remains on the surfaces of the metal nanowires so that the metal nanowires are thought to be suitably dispersed as utilizing their aggregation force.

The metal filler can contain other metal particles in addition to metal nanowires. By mixing other metal particles, the volume resistivity of a conductive material can be made smaller. In addition, metal nanowires are filled in a portion that has not been occupied with metal particles, and thus the number of metal nanowires composing the wire bundle portion is increased to improve conductivity.

Examples of other metal particles include particles of silver, gold, copper, nickel, rhodium, palladium, chromium, titanium, platinum, iron, and alloys thereof. In order to increase the number of points that metal fillers are contacted with each other, flaky metal particles, fibrous metal particles, or the like are preferred. Although the mean particle size of the metal particles is not particularly limited, it is preferably, for example, 2.5 $\mu$m or more, but not more than 15 $\mu$m. In the present specification, the values of the mean particle sizes of the metal particles were measured by using "Microtrac particle size distribution measurement device MT3300EX II" manufactured by NIKKISO Co. Ltd.

When the metal particles are flaky or fibrous, metal particle powder having the mean aspect ratio of 10 or more is preferably used. The mean aspect ratio is a value calculated from "the mean value of flake widths/the mean value of flake thicknesses" when metal particle powder is flaky, or a value calculated from "the mean value of fiber lengths/the mean value of fiber diameters" when metal particle powder is fibrous. The mean value of flake widths or the like can be determined by measuring the length of each of the particles by observing the metal particle powder with SEM, TEM, or the like, and calculating the arithmetic mean value from measurement values of the given number of particles. The number of particles to measure is preferably 20 or more.

The content of the metal filler in the conductive material according to the present invention can suitably be determined in view of conductivity and flexibility. For example, a mixing amount of the metal filler is preferably 350 parts by mass or less relative to 100 parts by mass of the polymer. In this case, at least 50 parts by mass or more of metal nanowires are preferred to be contained.

<Method for Manufacturing Conductive Material>

The conductive material according to the present invention can be manufactured by, for example, preparing a conductive paint by adding a metal filler to a solution in which a polymer is dissolved in a solvent; applying the prepared conductive paint onto a substrate; and drying the applied conductive paint by heating. When the polymer is crosslinked rubber, a crosslinking reaction may proceed during heating. If necessary, additives, such as plasticizers, processing aids, crosslinkers, vulcanization accelerators, vulcanization aids, age inhibitors, softeners, and colorants may be added to the conductive paint. Selection of a solvent for the conductive paint, that is, selection of a solvent that dissolves a polymer and disperses metal fillers is important to realize a structure in which wire bundle portions are dispersed in a polymer. Specifically, selecting a solvent that can dissolve both a polymer and a hydrophilic polymer that is attached on metal nanowires is preferred. For example, N-methyl-2-pyrrolidone and dimethylformamide can dissolve the polymer. When each of these solvents is used as alone, metal nanowires can be dispersed. However, if metal nanowires are dispersed in a solution in which a polymer is dissolved in N-methyl-2-pyrrolidone or dimethylformamide, solids and the solution may be separated to worsen liquid stability.

Examples of the substrate include, in addition to dielectric layers made of elastomers, films and sheets having flexibility or elasticity, which are composed of polyurethane, polyimide, polyethylene, polyethylene terephthalate (PET), polyethylene naphthalate (PEN), or the like. The method of applying the conductive paint may be various methods that are already known. Examples of the method include printing methods such as inkjet printing, flexo printing, gravure printing, screen printing, pad printing, and lithography; dipping; spraying, and bar coating. For example, when a conductive material according to the present invention is used as a material for electrodes and wirings of electronic parts such as transducers, the conductive material is preferably formed as a thin film in view of reducing sizes, reducing thicknesses, decreasing influence of deformation of dielectric layers as little as possible, and the like. For example, the thickness of the conductive material is preferably 4 $\mu$m or more, but not more than 100 $\mu$m.

Among the metal fillers, a method for manufacturing metal nanowires is not particularly limited. Metal nanowires can be manufactured by known methods, such as a liquid phase method, a vapor phase method, a gas atomizing method, and an aqueous electrolysis method. For example, mixing a metal compound solution in which a metal compound is dissolved in a solvent, a growth direction control agent solution in which a growth direction control agent is dissolved in a solvent, and a wire generator solution in which a wire generator is dissolved in a solvent; and reacting a metal compound in the mixture so that metal nanowires can grow in a longitudinal direction.

The metal compound can suitably be selected depending on types of metal nanowires. Examples of the metal compound include inorganic acid salts, such as nitrates, chlorides, sulfates, carbonates, chlorates, and perchlorates; and organic acid salts, such as acetate and lactates; which can supply metal ions. Among them, nitrates are preferable. As a growth direction control agent, a hydrophilic polymer, such as polyvinylpyrrolidone, polyvinyl alcohol, and a poly(meth)acrylic acid salt is used. As a wire generator, an inorganic chloride or an organic chloride, which can generate chloride ions, is used. Among them, sodium chloride is preferable because it easily forms metal nanoparticles that will be a core, because a residual salt of it can easily be removed, and the like. The solvent is not particularly limited as long as it can reduce metal ions. Examples of the solvent include polyols, such as ethylene glycol and propylene glycol; alcohols; and ethers.

The reaction may be conducted by suitably selecting conditions such as heating, pressurization, and microwave irradiation. For example, when a mixture is heated, the reaction temperature is preferably about 30°C to 290°C. The mixture will become clouded as the reaction proceeds. This allows generation of metal nanowires to be confirmed. After confirming cloudiness of the mixture, the reaction is preferred to continue for around 30 minutes. After the reaction is completed, the mixture is cooled if it has been heated during the reaction, and metal nanowires generated in the mixture are collected. The metal nanowires may be collected by a method, such as filtration, centrifugation, reprecipitation, and the like. The generated metal nanowires are preferably washed in order to remove a growth direction control agent attached on the surfaces of the metal nanowires.

<Transducer>

The transducer according to the present invention includes a dielectric layer made of an elastomer, a plurality of electrodes with the dielectric layer interposed therebetween, and wirings each connecting to corresponding one of the electrodes. In the transducer according to the present invention, the dielectric layer may be a single layer, or may be double or more layers. Here, "made of an elastomer" means that the base material of the dielectric layer is an elastomer. Accordingly, the dielectric layer may contain other components in addition to the elastomer component. Examples of the dielectric layer include various layers, such as elastomer layers containing only elastomers, high resistivity layers containing elastomers and insulating inorganic particles, ionic component-containing layers containing elastomers and an ionic component, and semiconductor-containing layers containing elastomers and semiconductors. In addition, the transducer according to the present invention may have a lamination structure in which dielectric layers and electrodes are laminated alternately.

In order to increase the displacement and the generative force of the transducer, the elastomer preferably has a relative dielectric constant (100 Hz) at a normal temperature of 2 or more, and more preferably 5 or more. Preferred examples of the elastomer include silicone rubber, nitrile rubber (NBR), hydrogenated nitrile rubber (H-NBR), an ethylene-propylene-diene copolymer (EPDM), acrylic rubber, urethane rubber, epichlorohydrin rubber, chlorosulfonated polyethylene, and chlorinated polyethylene.

In the transducer according to the present invention, either one or both of the electrodes and the wirings includes the conductive material according to the present invention. The structure and the manufacturing method of the conductive material according to the present invention are as described above, and thus are not described here. In the electrodes and the wirings of the transducer according to the present invention, the preferred embodiment of the conductive material according to the present invention is preferably employed. An embodiment of a capacitance sensor will next be described as one example of the transducer according to the present invention.

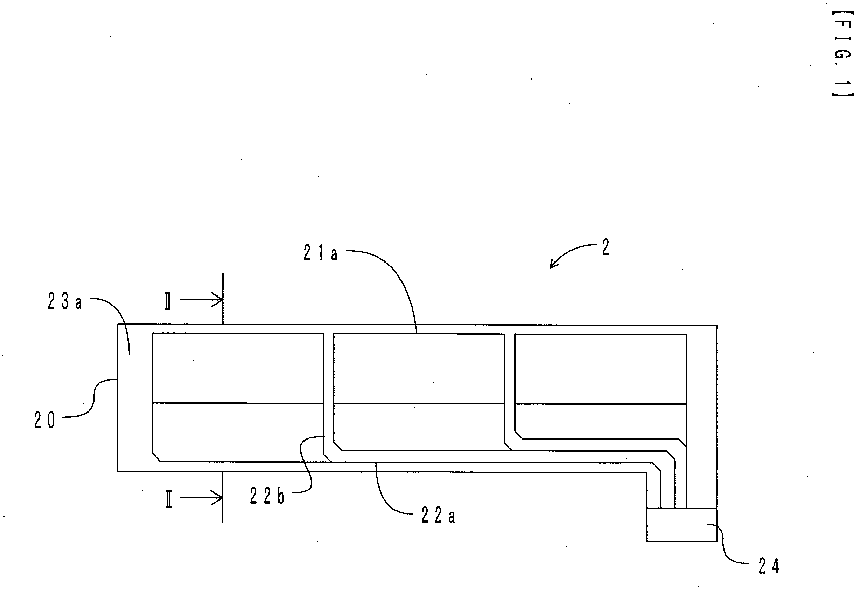

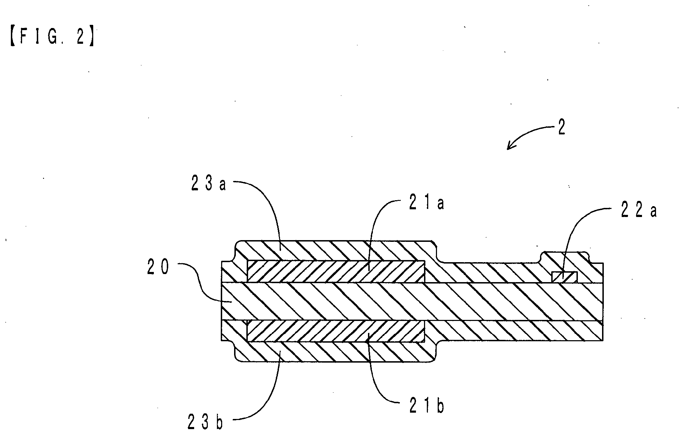

First, the configuration of a capacitance sensor in the present embodiment will be described. FIG. 1 is a top view of the capacitance sensor. FIG. 2 is a sectional view taken along line II-II in FIG. 1. As shown in FIG. 1 and FIG. 2, a capacitance sensor 2 includes a dielectric layer 20, a pair of electrodes 21a, 21b, wirings 22a, 22b, and cover films 23a, 23b.

The dielectric layer 20 is made of H-NBR and has a strip shape extending in the left-right direction. The dielectric layer 20 has a thickness of about 300 $\mu$m.

The electrode 21a has a rectangular shape. Three electrodes 21a are formed on the top face of the dielectric layer 20 by screen printing. Similarly, the electrode 21b has a rectangular shape. Three electrodes 21b are formed on the bottom face of the dielectric layer 20 to face the electrodes 21a with the dielectric layer 20 interposed between the electrodes 21a and 21b. The electrodes 21b are formed on the bottom face of the dielectric layer 20 by screen printing. In this manner, three pairs of the electrodes 21a, 21b are disposed with the dielectric layer 20 interposed therebetween. The electrodes 21a, 21b are made of the conductive material according to the present invention, in which the conductive material has acrylic rubber and silver nanowires, and has a structure in which wire bundle portions of silver nanowires are dispersed in the acrylic rubber (corresponding to the conductive film of Example 1 described later).

The wirings 22a are each connected to corresponding one of the electrodes 21a formed on the top face of the dielectric layer 20. The wiring 22a connects the electrode 21a to a connector 24. The wirings 22a are formed on the top face of the dielectric layer 20 by screen printing. Similarly, the wirings 22b are each connected to corresponding one of the electrodes 21b formed on the bottom face of the dielectric layer 20 (in FIG. 2, shown by dotted lines). The wiring 22b connects the electrode 21b to a connector (not shown). The wirings 22b are formed on the bottom face of the dielectric layer 20 by screen printing. The wirings 22a, 22b are made of the conductive material according to the present invention, which has acrylic rubber, silver nanowires, and flaky silver powder, and has a structure in which wire bundle portions of silver nanowires are dispersed in the acrylic rubber (corresponding to the conductive film of Example 2 described later).

The cover film 23a is made of acrylic rubber and has a strip shape extending in the left-right direction. The cover film 23a covers the top faces of the dielectric layer 20, the electrodes 21a, and the wirings 22a. Similarly, the cover film 23b is made of acrylic rubber and has a strip shape extending in the left-right direction. The cover film 23b covers the bottom faces of the dielectric layer 20, the electrodes 21b, and the wirings 22b.

Next, the movement of the capacitance sensor 2 will be described. For example, when the capacitance sensor 2 is pressed from above, the dielectric layer 20, the electrodes 21a, and the cover film 23a are monolithically bent downward. The compression reduces the thickness of the dielectric layer 20. Consequently, the capacitance between the electrodes 21a, 21b becomes large. A deformation by the compression can be detected on the basis of a change in the capacitance.

Next, advantageous effects of the capacitance sensor 2 will be described. According to the present embodiment, the electrodes 21a, 21b and the wirings 22a, 22b are flexible. Thus, the movement of the dielectric layer 20 is less likely to be restricted by the electrodes 21a, 21b and the wirings 22a, 22b. The capacitance sensor 2 thus has good responsivity. In addition, the electrodes 21a, 21b and the wirings 22a, 22b have high electric conductivity, and have electrical resistance that is less likely to increase even when the electrodes 21a, 21b and the wirings 22a, 22b are extended. Thus, the capacitance sensor 2 has a performance that is less likely to deteriorate due to the electrodes 21a, 21b and the wirings 22a, 22b. The capacitance sensor 2 therefore has excellent durability.

[Examples]

Next, the present invention will be explained in detail with Examples.

<Manufacture of Silver Nanowires>

First, an AgNO$_3$ solution, in which 12.99 g of silver nitrate (AgNO$_3$) is dissolved in 497.7 g of ethylene glycol; an NaCl solution serving as a wire generator, in which sodium chloride (NaCl) is dissolved in ethylene glycol (the concentration of NaCl: 0.1 mol/L); and a polyvinylpyrrolidone solution serving as a growth direction control agent, in which 22.5 g of poly(N-vinyl-2-pyrrolidone) (the weight-average molecular weight is 55,000) is dissolved in 449.7 g of ethylene glycol were prepared. Next, the AgNO$_3$ solution was added to the polyvinylpyrrolidone solution, and then 100.5 g of the NaCl solution was further added as stirred. The mixture of the AgNO$_3$ solution, the polyvinylpyrrolidone solution, and the NaCl solution was kept stirred at a room temperature for 40 minutes, and the mixture was added with stirring to 826.4 g of ethylene glycol that was heated to 130°C, with the rate of 300 mL/minute. Then, the mixture was reacted at 130°C for 2.5 hours with stirring. The mixture was heated to increase the temperature to 175°C, and the reaction was terminated at 2.5 hours after beginning to increase the temperature, and cloudiness of the mixture was confirmed. After the reaction was terminated, the mixture was cooled with water, acetone was added thereto, and then the mixture was left standing. After supernatant was removed, precipitated solids (silver nanowires) were collected.

Subsequently, the obtained silver nanowires were subjected to a washing process. First, isopropyl alcohol was added to the collected silver nanowires to prepare a dispersion liquid of the silver nanowires. Next, the dispersion liquid was heated to 80°C, and was stirred for 20 minutes (heating and stirring process). After the dispersion liquid was cooled, acetone was added thereto, and then the mixture was left standing. After supernatant was removed, precipitated silver nanowires were collected. The collected silver nanowires were subjected to the same heating and stirring process twice to obtain purified silver nanowires. According to the thermal gravimetric analysis, the metal component of the washed silver nanowires (hereinafter, referred to as "purified silver nanowires") was 98.4% by mass. Meanwhile, according to the thermal gravimetric analysis, the metal component of the silver nanowires before subjected to the washing process (hereinafter, referred to as "unpurified silver nanowires") was 74.8% by mass. In the thermal gravimetric analysis, about 5 mg of the silver nanowires was heated from a room temperature to 1,000°C with a rate of 20°C/minutes, and change in the mass due to the heating was measured.

<Manufacture of Conductive Material>

[Example 1]

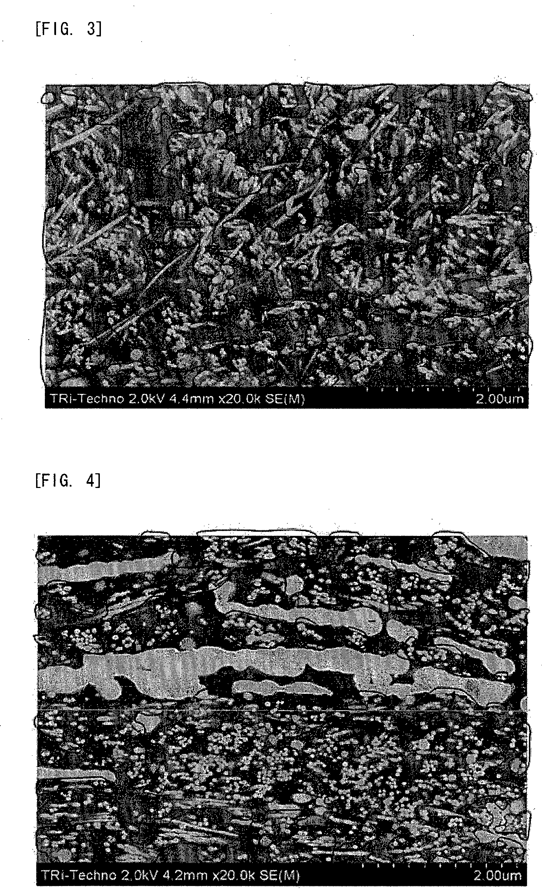

A conductive material whose polymer is acrylic rubber was manufactured. First, 100 parts by mass of a hydroxyl group-containing acrylic rubber polymer (Tg: -35°C, the weight-average molecular weight is about 900,000) that is a copolymer of n-butyl acrylate (98% by mass) and 2-hydroxyethyl methacrylate (2% by mass) and 0.1 part by mass of ethylenediamine that is a crosslinker were mixed in a roll mill to prepare an acrylic rubber composition. Next, the prepared acrylic rubber composition was dissolved in 2,300 parts by mass of butyl cellosolve acetate (manufactured by DAISHIN CHEMICAL Co., Ltd.) to prepare an acrylic rubber solution. To the acrylic rubber solution, 300 parts by mass of purified silver nanowires were added, and stirred to prepare a conductive paint. Then, the prepared conductive paint was applied onto a surface of a polyurethane sheet as a substrate by bar coating, and the applied conductive paint was dried at 150°C for 2 hours to manufacture a conductive film. The obtained conductive film is referred to as the conductive film of Example 1. The conductive film of Example 1 is included in the conductive material according to the present invention.
The section of the conductive film of Example 1 was observed with SEM. In FIG. 3, a sectional SEM picture of the conductive film of Example 1 is shown. As shown by portions surrounded with solid lines in FIG. 3, a number of wire bundle portions each formed of a plurality of silver nanowires assembled are present in the acrylic rubber. The silver nanowires composing the wire bundle portions are adjacent or contacted at a distance therebetween of less than 200 nm. The wire bundle portions are dispersed in acrylic rubber at a distance of less than 3 $\mu$m. According to the SEM picture, the maximum distance between adjacent wire bundle portions was 0.5 $\mu$m. The mean number of the silver nanowires composing one wire bundle portion was 40.7. The mean length of the silver nanowires in the longitudinal direction was 1,364 nm, and that in the transverse direction was 39 nm. Both of the mean lengths are arithmetic mean values of 20 silver nanowires (below is same as above).

[Example 2]

In the manufacture of the conductive film of Example 1, a mixing amount of purified silver nanowires was decreased to 200 parts by mass, and instead, 100 parts by mass of flaky silver powder (manufactured by FUKUDA METAL FOIL & POWDER Co., Ltd. "Ag-XF 301," mean particle size: 5.5 $\mu$m, mean aspect ratio: 25) was mixed to prepare a conductive paint. The mass ratio of the purified silver nanowires to the flaky silver powder was 2. The obtained conductive film is referred to as the conductive film of Example 2. The conductive film of Example 2 is included in the conductive material according to the present invention.
The section of the conductive film of Example 2 was observed with SEM. In FIG. 4, a sectional SEM picture of the conductive film of Example 2 is shown. As shown in FIG. 4, wire bundle portions, in which a plurality of silver nanowires are assembled (shown by portions surrounded with solid lines), and flaky silver particles are present in acrylic rubber. The silver nanowires composing the wire bundle portions are adjacent or contacted at a distance therebetween of less than 200 nm. The wire bundle portions are dispersed in acrylic rubber at a distance of less than 3 $\mu$m. According to the SEM picture, the maximum distance between adjacent wire bundle portions was 0.5 $\mu$m. The mean number of the silver nanowires composing one wire bundle portion was 44.7.

[Example 3]

In the manufacture of the conductive film of Example 1, a mixing amount of purified silver nanowires was decreased to 100 parts by mass, and instead, 200 parts by mass of flaky silver powder (same as above) was mixed to prepare a conductive paint. The mass ratio of the purified silver nanowires to the flaky silver powder was 0.5. Note that, in this Example, the mixing amount of butyl cellosolve acetate, which is a solvent for an acrylic rubber solution, was 1,800 parts by mass. The obtained conductive film is referred to as the conductive film of Example 3. The conductive film of Example 3 is included in the conductive material according to the present invention. When the section of the conductive film of Example 3 was observed with SEM, a structure in which the wire bundle portions are dispersed was observed. The maximum distance between adjacent wire bundle portions was 1.2 $\mu$m, and the mean number of the silver nanowires composing one wire bundle portion was 70.3.

[Example 4]

In the manufacture of the conductive film of Example 1, a mixing amount of purified silver nanowires was decreased to 200 parts by mass, and instead, 50 parts by mass of flaky silver powder (same as above) was mixed to prepare a conductive paint. The mass ratio of the purified silver nanowires to the flaky silver powder was 4. The obtained conductive film is referred to as the conductive film of Example 4. The conductive film of Example 4 is included in the conductive material according to the present invention. When the section of the conductive film of Example 4 was observed with SEM, a structure in which the wire bundle portions are dispersed was observed. The maximum distance between adjacent wire bundle portions was 0.5 $\mu$m, and the mean number of the silver nanowires composing one wire bundle portion was 50.6.

[Example 5]

In the manufacture of the conductive film of Example 1, a mixing amount of purified silver nanowires was decreased to 100 parts by mass, and instead, 250 parts by mass of flaky silver powder (same as above) was mixed to prepare a conductive paint. The mass ratio of the purified silver nanowires to the flaky silver powder was 0.4. The obtained conductive film is referred to as the conductive film of Example 5. The conductive film of Example 5 is included in the conductive material according to the present invention. When the section of the conductive film of Example 5 was observed with SEM, a structure in which the wire bundle portions are dispersed was observed. The maximum distance between adjacent wire bundle portions was 1.7 $\mu$m, and the mean number of the silver nanowires composing one wire bundle portion was 74.6.

[Example 6]

In the manufacture of the conductive film of Example 1, a mixing amount of purified silver nanowires was decreased to 50 parts by mass, and instead, 250 parts by mass of flaky silver powder (same as above) was mixed to prepare a conductive paint. The mass ratio of the purified silver nanowires to the flaky silver powder was 0.2. The obtained conductive film is referred to as the conductive film of Example 6. The conductive film of Example 6 is included in the conductive material according to the present invention. When the section of the conductive film of Example 6 was observed with SEM, a structure in which the wire bundle portions are dispersed was observed. The maximum distance between adjacent wire bundle portions was 2.8 $\mu$m, and the mean number of the silver nanowires composing one wire bundle portion was 80.3.

[Example 7]

A conductive film whose polymer is a polyester resin was manufactured. First, 100 parts by mass of a polyester resin ("elitel (registered trademark) EU3220" manufactured by UNITIKA Ltd., Tg: 5°C) was dissolved in 2,300 parts by mass of isophorone (manufactured by DAISHIN CHEMICAL Co., Ltd.) to prepare a polyester resin solution. To the polyester resin solution, 200 parts by mass of purified silver nanowires were added, and stirred to prepare a conductive paint. Then, the prepared conductive paint was applied onto a surface of a polyurethane sheet serving as a substrate by bar coating, and the applied conductive paint was dried at 150°C for 2 hours to manufacture a conductive film. The obtained conductive film is referred to as the conductive film of Example 7. The conductive film of Example 7 is included in the conductive material according to the present invention. When the section of the conductive film of Example 7 was observed with SEM, a structure in which the wire bundle portions are dispersed was observed. The maximum distance between adjacent wire bundle portions was 0.6 $\mu$m, and the mean number of the silver nanowires composing one wire bundle portion was 46.2.

[Example 8]

In the manufacture of the conductive film of Example 7, in addition to purified silver nanowires, 100 parts by mass of flaky silver powder (same as above) was mixed to prepare a conductive paint. The mass ratio of the purified silver nanowires to the flaky silver powder was 2. Note that, in this Example, the solvent of the polyester resin solution was changed to butyl cellosolve acetate (same as above). The obtained conductive film is referred to as the conductive film of Example 8. The conductive film of Example 8 is included in the conductive materials according to the present invention. When the section of the conductive film of Example 8 was observed with SEM, a structure in which the wire bundle portions are dispersed was observed. The maximum distance between adjacent wire bundle portions was 0.7 $\mu$m, and the mean number of the silver nanowires composing one wire bundle portion was 47.8.

[Example 9]

A conductive film was manufactured in the same manner as in the conductive film of Example 2, except that the crosslinker and the method for preparing a conductive paint were changed. First, 100 parts by mass of a hydroxyl group-containing acrylic rubber polymer (same as above) that is a copolymer of n-butyl acrylate and 2-hydroxyethyl methacrylate was dissolved in 2,300 parts by mass of butyl cellosolve acetate (same as above) to prepare an acrylic rubber solution. Next, to the prepared acrylic rubber solution, 3 parts by mass of hexamethylene diisocyanate that is a crosslinker, 200 parts by mass of purified silver nanowires, and 100 parts by mass of flaky silver powder (same as above) were added, and stirred to prepare a conductive paint. The mass ratio of the purified silver nanowires to the flaky silver powder was 2. The obtained conductive film is referred to as the conductive film of Example 9. The conductive film of Example 9 is included in the conductive material according to the present invention.
When the section of the conductive film of Example 9 was observed with SEM, a structure in which the wire bundle portions are dispersed was observed. The maximum distance between adjacent wire bundle portions was 0.7 $\mu$m, and the mean number of the silver nanowires composing one wire bundle portion was 41.6.

[Example 10]

A conductive film whose polymer is silicone rubber (Tg: -120°C) was manufactured. First, 100 parts by mass of the silicone rubber polymer (two-part liquid silicone "KE1935" manufactured by Shin-Etsu Chemical Co., Ltd.) was dissolved in 1,000 parts by mass of isoparaffinic hydrocarbon ("IP SOLVENT 2028" manufactured by Idemitsu Kosan Co., Ltd.) to prepare a silicone solution. To the silicone solution, 200 parts by mass of purified silver nanowires and 100 parts by mass of flaky silver powder (same as above) were added, and stirred to prepare a conductive paint, similarly to the conductive film of Example 2. The mass ratio of the purified silver nanowires to the flaky silver powder was 2. Then, the prepared conductive paint was applied onto a surface of a polyurethane sheet serving as a substrate by bar coating, and the applied conductive paint was dried at 150°C for 2 hours to manufacture a conductive film. The obtained conductive film is referred to as the conductive film of Example 10. The conductive film of Example 10 is included in the conductive material according to the present invention. When the section of the conductive film of Example 10 was observed with SEM, a structure in which the wire bundle portions are dispersed was observed. The maximum distance between adjacent wire bundle portions was 1.2 $\mu$m, and the mean number of the silver nanowires composing one wire bundle portion was 65.0.

[Example 11]

In the manufacture of the conductive film of Example 1, a mixing amount of purified silver nanowires was decreased to 100 parts by mass, and 1,500 parts by mass of butyl cellosolve acetate that is a solvent for acrylic rubber solutions was mixed to prepare a conductive paint. The obtained conductive film is referred to as the conductive film of Example 11. The conductive film of Example 11 is included in the conductive material according to the present invention. When the section of the conductive film of Example 11 was observed with SEM, a structure in which the wire bundle portions are dispersed was observed. The maximum distance between adjacent wire bundle portions was 2.1 $\mu$m, and the mean number of the silver nanowires composing one wire bundle portion was 49.0.

[Example 12]

In the method for manufacturing the conductive film of Example 1, "purified silver nanowires further grown in a longitudinal direction" that were manufactured by the method described later were used instead of purified silver nanowires, and flaky silver powder was also mixed to prepare a conductive paint. That is, 66 parts by mass of the purified silver nanowires further grown in a longitudinal direction and 33 parts by mass of flaky silver powder (same as above) were added to the prepared acrylic rubber solution, and stirred to prepare a conductive paint. The mass ratio of the purified silver nanowires further grown in a longitudinal direction to the flaky silver powder was 2. Note that, in this Example, the mixing amount of butyl cellosolve acetate, which is a solvent for an acrylic rubber solution, was 1,500 parts by mass. The obtained conductive film is referred to as the conductive film of Example 12. The conductive film of Example 12 is included in the conductive materials according to the present invention. When the section of the conductive film of Example 12 was observed with SEM, a structure in which the wire bundle portions are dispersed was observed. The maximum distance between adjacent wire bundle portions was 2.5 $\mu$m, and the mean number of the silver nanowires composing one wire bundle portion was 55.0. The mean length of the silver nanowires in the longitudinal direction was 8,320 nm, and that in the transverse direction was 52 nm.

Hereinafter, a method for manufacturing the purified silver nanowires further grown in a longitudinal direction will be explained. First, an AgNO$_3$ solution, in which 12.99 g of silver nitrate (AgNO$_3$) was dissolved in 497.7 g of ethylene glycol; an NaCl solution serving as a wire generator, in which sodium chloride (NaCl) was dissolved in ethylene glycol (the concentration of NaCl: 0.1 mol/L); and a polyvinylpyrrolidone solution serving as a growth direction control agent, in which 22.5 g of poly(N-vinyl-2-pyrrolidone) (the weight-average molecular weight is 55,000) was dissolved in 449.7 g of ethylene glycol were prepared. Next, the AgNO$_3$ solution was added to the polyvinylpyrrolidone solution, and then 50.3 g of the NaCl solution was further added as stirred. The mixture of the AgNO$_3$ solution, the polyvinylpyrrolidone solution, and the NaCl solution was kept stirred at a room temperature for 40 minutes, and the mixture was added with stirring to a reaction tank that was heated to 130°C, with the rate of 120 mL/minute. The mixture was kept stirred at 130°C for 1 hour, and then an AgNO$_3$ solution in which 36.4g of silver nitrate was dissolved in 174.4 g of ethylene glycol; and a polyvinylpyrrolidone solution in which 8.82 g of poly(N-vinyl-2-pyrrolidone) (same as above) was dissolved in 174.4 g of ethylene glycol; were added with stirring to the mixture respectively with the rate of 1 mL/minute. The reaction was terminated after the mixture was kept stirred for 4 hours, and cloudiness of the mixture was confirmed. After the reaction was terminated, the mixture was cooled with water, and acetone was added thereto, and then the mixture was left standing. After supernatant was removed, precipitated solids (silver nanowires) were collected.

Subsequently, the obtained silver nanowires were subjected to a washing process. First, isopropyl alcohol was added to the collected silver nanowires to prepare a dispersion liquid of the silver nanowires. Next, the dispersion liquid was heated to 80°C, and was stirred for 20 minutes (heating and stirring process). After the dispersion liquid was cooled, acetone was added thereto, and then the mixture was left standing. After supernatant was removed, precipitated silver nanowires were collected. The collected silver nanowires were subjected to the same heating and stirring process twice to obtain purified silver nanowires. According to the thermal gravimetric analysis conducted in the same manner as above, the metal component of the washed silver nanowires (purified silver nanowires further grown in a longitudinal direction) was 88.4% by mass.

[Example 13]

In the manufacture of the conductive film of Example 12, a conductive paint was prepared without mixing flaky silver powder. The obtained conductive film is referred to as the conductive film of Example 13. The conductive film of Example 13 is included in the conductive material according to the present invention. When the section of the conductive film of Example 13 was observed with SEM, a structure in which the wire bundle portions are dispersed was observed. The maximum distance between adjacent wire bundle portions was 2.0 $\mu$m, and the mean number of the silver nanowires composing one wire bundle portion was 39.0.

[Comparative Example 1]

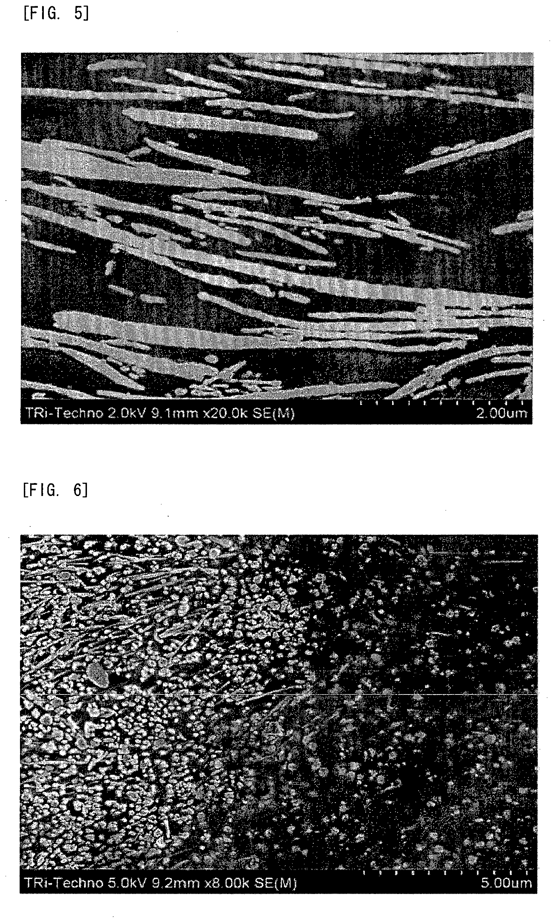

In the manufacture of the conductive film of Example 1, 300 parts by mass of flaky silver powder (same as above) was mixed instead of purified silver nanowires to prepare a conductive paint. Note that, in this Comparative Example, the mixing amount of butyl cellosolve acetate, which is a solvent for an acrylic rubber solution, was 300 parts by mass. The obtained conductive film is referred to as the conductive film of Comparative Example 1.
The section of the conductive film of Comparative Example 1 was observed with SEM. In FIG 5, a sectional SEM picture of the conductive film of Comparative Example 1 is shown. As shown in FIG. 5, flaky silver particles are dispersed in acrylic rubber.

[Comparative Example 2]

In the manufacture of the conductive film of Example 1, 300 parts by mass of unpurified silver nanowires was mixed instead of purified silver nanowires to prepare a conductive paint. The obtained conductive film is referred to as the conductive film of Comparative Example 2.
The section of the conductive film of Comparative Example 2 was observed with SEM. In FIG. 6, a sectional

**EP 3 056 547 B1**

SEM picture of the conductive film of Comparative Example 2 is shown. As shown in FIG. 6, aggregates formed by aggregation of a large number of silver nanowires occupy the left half of the SEM picture. Wire bundle portions of silver nanowires are hardly seen.

[Comparative Example 3]

In the manufacture of the conductive film of Example 1, a mixing amount of purified silver nanowires was decreased to 200 parts by mass, and a solvent for an acrylic rubber solution was changed from butyl cellosolve acetate to isoparaffinic hydrocarbon (same as above) to prepare a conductive paint. The obtained conductive film is referred to as the conductive film of Comparative Example 3. When the section of the conductive film of Comparative Example 3 was observed with SEM, aggregates formed by aggregation of a large number of silver nanowires were observed.

<Evaluation>

The conduction characteristics of each conductive film of Examples and Comparative Examples were evaluated.

[Method for Evaluation]

(1) Volume Resistivity

The volume resistivity of each of the conductive films of Examples and Comparative Examples was measured by using the resistivity meter "Loresta (registered trademark) GP" manufactured by Mitsubishi Chemical Analytech Co., Ltd.

(2) Retentivity of Conductivity against Extension and Contraction

First, a test piece having the shape of dumbbell No. 2 specified in JIS K6251 (2010) was prepared from each of the conductive films of Examples and Comparative Examples. The test piece (conductive film) was placed on a polyurethane sheet that is a substrate. Next, the electrical resistance between both ends of the test piece in the length direction under an unextended condition (natural condition) was measured by using the measurement system ("PXIe-1071/PXI-2530B" manufactured by National Instruments Japan Corporation). Subsequently, both ends of the test piece in the length direction were held together with the substrate by a gripper, and as one end was fixed, the other end was horizontally moved back and forth, so that the test piece was extended or contraction. The extension percentage of the test piece at the time of extension was 40%, and extension and contraction were repeated 5,500 times. The extension percentage of the test piece was a value calculated according to the equation (1) below.

$$\text{Extension percentage (\%)} = (\Delta L_0 / L_0) \times 100 \quad (1)$$

[$L_0$: the gauge length of a test piece, and $\Delta L_0$: an increase in the gauge length of the test piece by extension]
Each time a test piece was extended, the electrical resistance between the two ends of the test piece in the length direction was measured by using the measurement system (same as above) in order to find the maximum resistance value at the time of extension or contraction. Then, the maximum resistance value was divided by the resistance value in the unextended condition to calculate the rate of increase in the electrical resistance.

[Evaluation Results]

In Tables 1 and 2, evaluation results of the conductive films of Examples are shown. In Table 3, evaluation results of the conductive films of Comparative Examples are shown.

[Table 1]

| | | | Example 1 | Example 2 | Example 3 | Example 4 | Example 5 | Example 6 | Example 7 | Examples 8 |
|---|---|---|---|---|---|---|---|---|---|---|
| Mixing (Part (s) by mass) | Polymer | Acrylic rubber | 100 | 100 | 100 | 100 | 100 | 100 | - | - |
| | | Polyester resin | - | - | - | - | - | - | 100 | 100 |
| | Metal filler | Purified silver nanowires | 300 | 200 | 100 | 200 | 100 | 50 | 200 | 200 |
| | | Unpurified silver nanowires | - | - | - | - | - | - | - | - |
| | | Flaky silver powder (mean aspect ratio: 25) | - | 100 | 200 | 50 | 250 | 250 | - | 100 |
| | Solvent | Butyl cellosolve acetate | 2300 | 2300 | 1800 | 2300 | 2300 | 2300 | - | 2300 |
| | | Isophorone | - | - | - | - | - | - | 2300 | - |
| | | Isoparaffinic hydrocarbon | - | - | - | - | - | - | - | - |
| Silver nanowires / Flaky silver powder (mass ratio) | | | - | 2 | 0.5 | 4 | 0.4 | 0.2 | - | 2 |
| Presence of wire bundle portion (in which silver nanowires are assembled at a distance of less than 200 nm) | | | Yes | Yes | Yes | Yes | Yes | Yes | Yes | Yes |
| Average number of silver nanowires composing one wire bundle portion | | | 40.7 | 44.7 | 70.3 | 50.6 | 74.6 | 80.3 | 46.2 | 47.8 |
| Maximum distance between adjacent wire bundle portions [$\mu$m] | | | 0.5 | 0.5 | 1.2 | 0.5 | 1.7 | 2.8 | 0.6 | 0.7 |
| Character -istics | Volume resistivity [$\Omega$·cm] | | $4.6\times10^{-4}$ | $1.5\times10^{-4}$ | $1.7\times10^{-4}$ | $2.2\times10^{-4}$ | $1.4\times10^{-4}$ | $13\times10^{-4}$ | $6.5\times10^{-3}$ | $3.0\times10^{-4}$ |
| | Retentivity of conductivity against extension and contraction | Electrical resistance value in unextended condition: R1[$\Omega$] | 3 | 2 | 3 | 2.9 | 2.7 | 3 | 7 | 2.8 |
| | | Maximum electrical resistance value at the time of extension or contraction: R2 [$\Omega$] | 10 | 25 | 100 | 30 | 116 | 200 | 100 | 45 |
| | | Rate of increase of electrical resistance (R2/R1) | 3.3 | 12.5 | 33.3 | 10.3 | 43.0 | 66.7 | 14.3 | 16.1 |

[Table 2]

| | | | Example 9 | Example 10 | Example 11 | Example 12 | Example 13 |
|---|---|---|---|---|---|---|---|
| Mixing (Part(s) by mass) | Polymer | Acrylic rubber | 100 | - | 100 | 100 | 100 |
| | | Silicone rubber | - | 100 | - | - | - |
| | Metal filler | Purified silver nanowires | 200 | 200 | 100 | - | - |
| | | Purified silver nanowires further grown in a longitudinal direction | - | - | - | 66 | 66 |
| | | Flaky silver powder (mean aspect ratio: 25) | 100 | 100 | - | 33 | - |
| | Solvent | Butyl cellosolve acetate | 2300 | - | 1500 | 1500 | 1500 |
| | | Isoparaffinic hydrocarbon | - | 1000 | - | - | - |
| Silver nanowires / Flaky silver powder (mass ratio) | | | 2 | 2 | - | 2 | - |
| Presxence of wire bundle portion (in which silver nanowires are assembled at a distance of less than 200 nm) | | | Yes | Yes | Yes | Yes | Yes |
| Average number of silver nanowires composing one wire bundle portion | | | 41.6 | 65.0 | 49.0 | 55.0 | 39.0 |
| Maximum distance between adjacent wire bundle portions [$\mu$m] | | | 0.7 | 1.2 | 2.1 | 2.5 | 2.0 |
| Character-istics | Volume resistivity [$\Omega \cdot$cm] | | $4.1 \times 10^{-4}$ | $3.3 \times 10^{-4}$ | $2.5 \times 10^{-3}$ | $1.6 \times 10^{-3}$ | $2.6 \times 10^{-3}$ |
| | Retentivity of conductivity against extension and contraction | Electrical resistance value in unextended condition: R1 [$\Omega$] | 9 | 17 | 4 | 6 | 5 |
| | | Maximum electrical resistance value at the time of extension or contraction: R2 [$\Omega$] | 45 | 300 | 11 | 50 | 13 |
| | | Rate of increase of electrical resistance (R2/R1) | 5 | 17.8 | 2.8 | 8.3 | 2.6 |

[Table 3]

| | | | Comparative Example 1 | Comparative Example 2 | Comparative Example 3 |
|---|---|---|---|---|---|
| Mixing (Part (s) by mass) | Polymer | Acrylic rubber | 100 | 100 | 100 |
| | | Polyester resin | - | - | - |
| | Metal filler | Purified silver nanowires | - | - | 200 |
| | | Unpurified silver nanowires | - | 300 | - |
| | | Flaky silver powder (mean aspect ratio: 25) | 300 | - | - |
| | Solvent | Butyl cellosolve acetate | 300 | 2300 | - |
| | | Isophorone | - | - | - |
| | | Isoparaffinic hydrocarbon | - | - | 2300 |
| Silver nanowires / Flaky silver powder (mass ratio) | | | - | - | - |
| Presence of wire bundle portion (in which silver nanowires are assembled at a distance of less than 200 nm) | | | No | Yes | Yes |
| Average number of silver nanowires composing one wire bundle portion | | | - | >200 | >200 |
| Maximum distance between adjacent wire bundle portions [$\mu$m] | | | - | >3 | >3 |
| Character-istics | Volume resistivity [$\Omega\cdot$cm] | | $8.5\times10^{-5}$ | $4.5\times10^{-3}$ | $9.0\times10^{-3}$ |
| | Retentivity of conductivity against extension and contraction | Electrical resistance value in unextended condition: R1[$\Omega$] | 2 | 10 | 10 |
| | | Maximum electrical resistance value at the time of extension or contraction: R2 [$\Omega$] | >1000 | >1000 | >1000 |
| | | Rate of increase of electrical resistance (R2/R1) | >500 | >100 | >100 |

As shown in Tables 1 and 2, the volume resistivity of each of the conductive films of Examples 1 to 13, which has a structure in which the wire bundle portions are dispersed, was small, and the rate of increase in the electrical resistance when extension and contraction were repeated was also 100 times or less. Particularly in each of the conductive films of Examples 1, 7, 11, and 13, which contain only silver nanowires as metal fillers, the rate of increase in the electrical resistance when extension and contraction were repeated was smaller than that of each of the conductive films having the same polymers but containing flaky silver powder. In addition, in each of the conductive films of Examples 2 to 6, and 8, in which flaky silver powder was mixed, the volume resistivity was smaller than that of each of the conductive films having the same polymers but containing silver nanowires only.

On the other hand, in the conductive film of Comparative Example 1, which does not contain any silver nanowires, although the volume resistivity was the smallest, the rate of increase in the electrical resistance when extension and contraction were repeated was over 500 times. That is, the electrical resistance was greatly increased at the time of extension. In addition, in the conductive film of Comparative Example 2, which contains unpurified silver nanowires, the silver nanowires were aggregated, and thus a structure in which the wire bundle portions are dispersed could not be realized. Accordingly, the rate of increase in the electrical resistance when extension and contraction were repeated was over 100 times. In addition, in the conductive film of Comparative Example 3, a structure in which the wire bundle portions are dispersed could not be realized, although the conductive film contains purified silver nanowires. In the conductive film of Comparative Example 3, isoparaffinic hydrocarbon whose compatibility to polyvinylpyrrolidone is low was used as a solvent of an acrylic rubber solution. A small amount of polyvinylpyrrolidone remained on the surfaces of purified silver nanowires, and thus the silver nanowires were thought to be easily aggregated in the conductive paint

15

using isoparaffinic hydrocarbon as a solvent.

According to the results described above, it was confirmed that a conductive material according to the present invention has excellent conductivity, and electrical resistance thereof is not easily increased even if extension and contraction are repeated.

INDUSTRIAL APPLICABILITY

The conductive material according to the present invention is preferably used as electrodes and wirings of flexible transducers. The conductive material is also preferred as a wiring material of flexible wiring boards used for the control of moving parts of robots and industrial machines, wearable devices, flexible displays, and other devices. The conductive material is also preferably used for electromagnetic wave shields and electrically conductive adhesives, which are placed on portions subjected to deformation.

**Claims**

1. A conductive material **characterized by** comprising:

   a polymer having a glass transition temperature (Tg) of 25°C or below; and a metal filler containing metal nanowires, wherein
   an average length in a transverse direction of the metal nanowire is 200 nm or less,
   the conductive material includes a structure in which wire bundle portions each formed by assembling the metal nanowires are dispersed in the polymer, and
   the number of metal nanowires composing one of the wire bundle portions is not more than 100.

2. The conductive material according to claim 1, wherein a metal component in the metal nanowires is 85% by mass or more, but not more than 99.5% by mass.

3. The conductive material according to claim 1 or 2, wherein the metal filler further includes flaky metal particles.

4. The conductive material according to any one of claims 1 to 3, wherein the metal nanowires include silver.

5. The conductive material according to any one of claims 1 to 4, wherein a mixing amount of the metal filler is 350 parts by mass or less relative to 100 parts by mass of the polymer.

6. The conductive material according to any one of claims 1 to 5, wherein the distance between the wire bundle portions adjacent to each other is less than 3 $\mu$m.

7. The conductive material according to claim 3, wherein the mean particle size of the flaky metal particles is 2.5 $\mu$m or more, but not more than 15 $\mu$m.

8. The conductive material according to claim 3, wherein the mean aspect ratio of the flaky metal particles is 10 or more.

9. The conductive material according to any one of claims 1 to 8, wherein the polymer is one or more type(s) selected from acrylic rubber, polyester resins and polyester urethane resins.

10. A transducer **characterized by** comprising:

    a dielectric layer made of an elastomer; a plurality of electrodes with the dielectric layer interposed therebetween; and wirings each connecting to corresponding one of the electrodes, wherein
    either one or both of the electrodes and the wirings include the conductive material as claimed in any one of claims 1 to 9.

**Patentansprüche**

1. Leitfähiges Material, **dadurch gekennzeichnet, dass** es umfasst:

ein Polymer mit einer Glasübergangstemperatur (Tg) von 25°C oder darunter; und einen Metall-Füllstoff, enthaltend Metall-Nanodrähte, wobei

eine gemittelte Länge in einer Querrichtung des Metall-Nanodrahts 200 nm oder weniger beträgt,

das leitfähige Material eine Struktur beinhaltet, in der Drahtbündelbereiche, die jeweils durch Zusammenfügen der Metall-Nanodrähte gebildet sind, in dem Polymer verteilt sind und die Anzahl der Metall-Nanodrähte, die einen der Drahtbündelbereiche zusammensetzen, nicht mehr als 100 beträgt.

2. Leitfähiges Material nach Anspruch 1, wobei ein Metallbestandteil in den Metall-Nanodrähten 85 Massen% oder mehr, aber nicht mehr als 99,5 Massen%, beträgt.

3. Leitfähiges Material nach Anspruch 1 oder 2, wobei der Metall-Füllstoff weiter flockige Metallteilchen beinhaltet.

4. Leitfähiges Material nach einem der Ansprüche 1 bis 3, wobei die Metall-Nanodrähte Silber beinhalten.

5. Leitfähiges Material nach einem der Ansprüche 1 bis 4, wobei eine Mischungsmenge des Metall-Füllstoffs 350 Massenteile oder weniger, bezogen auf 100 Massenteile des Polymers, beträgt.

6. Leitfähiges Material nach einem der Ansprüche 1 bis 5, wobei der Abstand zwischen den zueinander benachbarten Drahtbündelbereichen weniger als 3 $\mu$m beträgt.

7. Leitfähiges Material nach Anspruch 3, wobei die mittlere Teilchengröße der flockigen Metallteilchen 2,5 $\mu$m oder mehr, aber nicht mehr als 15 $\mu$m, beträgt.

8. Leitfähiges Material nach Anspruch 3, wobei die mittlere Verhältniszahl der flockigen Metallteilchen 10 oder mehr beträgt.

9. Leitfähiges Material nach einem der Ansprüche 1 bis 8, wobei das Polymer eine oder mehrere Art(en) ist, ausgewählt aus Acrylkautschuk, Polyesterharzen und Polyesterurethanharzen.

10. Wandler, **dadurch gekennzeichnet, dass** er umfasst:

eine dielektrische Schicht, hergestellt aus einem Elastomer; eine Mehrzahl von Elektroden mit der dielektrischen Schicht dazwischen angeordnet; und

Verkabelungen, die jeweils mit einer der entsprechenden Elektroden verbinden, wobei

entweder eine oder beide der Elektroden und der Verkabelungen das leitfähige Material nach einem der Ansprüche 1 bis 9 beinhalten.

**Revendications**

1. Matériau conducteur **caractérisé en ce qu'**il comprend:

un polymère présentant une température de transition vitreuse (Tg) de 25°C ou moins; et une charge métallique contenant des nanofils de métal, dans lequel

la longueur moyenne dans le sens transversal du nanofil de métal est de 200 nm ou moins,

le matériau conducteur comprend une structure dans laquelle des parties de faisceau de fil chacun formées par assemblage des nanofils de métal sont dispersées dans le polymère, et le nombre de nanofils de métal composant l'une des parties de faisceau de fil ne dépasse pas 100.

2. Matériau conducteur selon la revendication 1, dans lequel un composant de métal dans les nanofils de métal est de 85% en masse ou plus, mais ne dépasse pas 99.5% en masse.

3. Matériau conducteur selon la revendication 1 ou 2, dans lequel la charge métallique comprend en outre des particules de métal lamellaires.

4. Matériau conducteur selon l'une quelconque des revendications 1 à 3, dans lequel les nanofils de métal comprennent de l'argent.

**5.** Matériau conducteur selon l'une quelconque des revendications 1 à 4, dans lequel une quantité de mélange de la charge métallique est de 350 parties en masse ou moins sur base de 100 parties en masse du polymère.

**6.** Matériau conducteur selon l'une quelconque des revendications 1 à 5, dans lequel la distance entre les parties de faisceau de fil adjacentes l'une à l'autre est inférieure à 3 μm.

**7.** Matériau conducteur selon la revendication 3, dans lequel la dimension particulaire moyenne des particules de métal lamellaires est de 2.5 μm ou plus, mais ne dépasse pas 15 μm.

**8.** Matériau conducteur selon la revendication 3, dans lequel le rapport d'aspect moyen des particules de métal lamellaires est de 10 ou plus.

**9.** Matériau conducteur selon l'une quelconque des revendications 1 à 8, dans lequel le polymère est l'un ou plusieurs type(s) sélectionnés parmi le caoutchouc acrylique, les résines de polyester et les résines de polyester uréthane.

**10.** Transducteur **caractérisé en ce qu'**il comprend:

une couche diélectrique en élastomère; une pluralité d'électrodes avec la couche diélectrique intercalée entre elles; et des fils connectant chacun les électrodes correspondantes, dans lequel
soit l'une, soit les deux des électrodes et les fils comprennent le matériau conducteur selon l'une quelconque des revendications 1 à 9.

[FIG. 1]

[F I G. 2]

[FIG. 3]

TRi-Techno 2.0kV 4.4mm x20.0k SE(M)　　　　2.00um

[FIG. 4]

TRi-Techno 2.0kV 4.2mm x20.0k SE(M)　　　　2.00um

[FIG. 5]

TRi-Techno 2.0kV 9.1mm x20.0k SE(M)          2.00um

[FIG. 6]

TRi-Techno 5.0kV 9.2mm x8.00k SE(M)          5.00um

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7220131 B
- JP 2012138260 A
- JP 2010153364 A
- JP 2009140788 A
- WO 2009107694 A
- JP 2011070968 A